# EUROPÄISCHE PATENTANMELDUNG

(11) **EP 2 017 887 A1**
(43) Date of publication of application: **21.01.2009**
(21) Application number: 07112828.4
(22) Date of filing: 20.07.2007
(51) Int. Cl.: H01L 23/31, H01L 23/051

(54) **Package for electronic components and method for packaging semiconductor devices**

(71) Applicant: ABB Research Ltd., 8050 Zürich (CH)
(72) Inventor: Knapp, Wolfgang, , CH-5600 Lenzburg (CH); Häderli, Christoph, , CH-8047 Zürich (CH)
(74) Representative: ABB Patent Attorneys

(57) **Abstract**

A semiconductor module (100) comprises a base member (107), a semiconductor die (101), a fastening unit (106) for fastening the semiconductor die (101) to the base member (107) and an insulating foil (201). The semiconductor die includes contacting units (103, 104) for electrical connection of the semiconductor die (101) to external circuit units and a planar edge termination unit (102a - 102n). The planar edge termination unit (102a - 102n) is insulated by the insulating foil (201) which is provided as a polymeric foil, a polyamide foil, a ceramic foil and/or a fibre reinforced sheet.

## Description

### BACKGROUND

The present invention in general relates to packaging of electronic components such as semiconductor dies. In particular, the present invention relates to packaging units for electronic power devices where insulation with respect to high voltages has to be provided.

The semiconductor module may comprise power devices with a flat shape and cooling members for dissipation of heat generated by the semiconductor dies contained in the semiconductor module. Such semiconductor modules for example are provided for electric vehicles and electric hybrid vehicles that are configured to run by driving an onboard AC electric motor through DC to AC conversion of a direct current from a battery to alternative current using an inverter. This inverter includes a plurality of semiconductor modules.

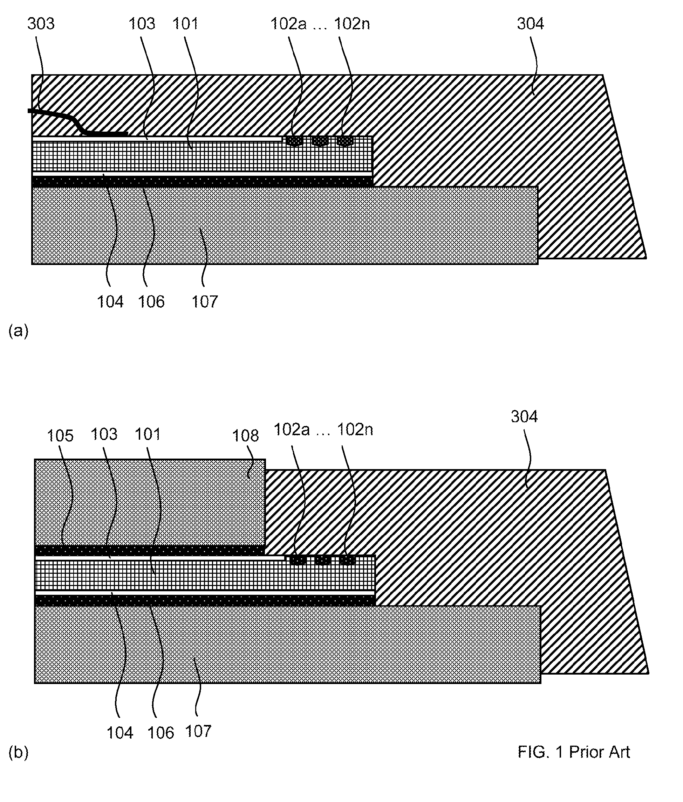

The present invention is applicable to power modules which have to be packaged. The final assembly of the power module may comprise either a single - or double - step sealing process using a moulding compound. A semiconductor module to be packaged generally comprises a base member and a semiconductor die which is fixed on top of the base member, as shown in Fig. 1(a).

Contacting units 103 and 104 are provided for an electrical connection of the semiconductor die 101 to external circuit units (not shown in Fig.1(a)). If the semiconductor die 101 is a high power semiconductor, high voltages are applied between different contacting units such that the high voltage difference is applied between upper and lower contacting units. In order to provide a controlled electric field reduction, the semiconductor die 101 furthermore comprises termination units 102a-102n, referred to as planar edge termination unit.

A fastening unit 106, which for example is provided as an adhesive layer, is provided for fastening the semiconductor die, e.g. the second contacting unit 104 to the base member 107. As shown in the example of Fig. 1(a), the first contacting unit 103 is provided with a bonding wire 303 for an electrical contact. Conventionally the semiconductor module is insulated by using a moulding compound 304 which is applied on top of the base member 107, the semiconductor die 101, the first contacting unit 103, the bonding wire 303 and the planar edge termination units 102a-n.

Fig. 1(b) shows another conventional semiconductor module. In addition to the configuration shown in Fig. 1(a) a top side member 108 is provided on top of the first contacting unit 103, wherein the top side member 108 is fixed to the first contacting unit 103 by using another fastening unit 105. As the fastening unit 106, the fastening unit 105 may be provided as an adhesive layer.

In contrast to the arrangement shown in 1(a), the semiconductor module shown in Fig. 1(b) comprises a moulding compound 304 which is only provided on top of the base member 107 and the planar edge termination units 102a-102n of the semiconductor die 101.

The patent application no. US 2005/0012206 A1 discloses a semiconductor unit with a cooling system, wherein mould resin is provided as an insulation member. The mould resin has the largest linear expansion coefficient among all the members composing the semiconductor module and expands in a direction that may produce a stress to the semiconductor module when heat is generated in the semiconductor device.

In the US patent no. US 6,377,461 B1, a method of power electronic packaging is described, wherein thermal base plate sub-assemblies include integral, high performance heat exchangers for providing a low thermal resistance path to the ambient. The semiconductor module disclosed in US 6,377,461 B1 is sealed by the use of a single - or a double - step sealing process.

It is expedient that semiconductor modules comprise insulation units and units for mechanical protection. Semiconductor modules including high voltage semiconductor devices like diodes and switches (IGBTs, FETs, etc.) must be capable to handle electric fields within their bulk, i.e. off-state or reverse biased diodes. Furthermore such high voltage semiconductor devices must be capable to handle high electric fields across their edge.

To this end, planar edge termination units are provided in many chip-type devices. Such a planar edge termination unit is provided for example as a guard ring structure that controls the field along a top surface of a semiconductor die contained in a semiconductor module. This arrangement allows wafer cutting without any insulation degradation.

The provision of such planar edge termination units wastes semiconductor area, which is then lost for active current conduction area. For higher blocking voltages, the zone occupied by the planar edge termination units must be wider and the ratio between active areas and edge termination areas disadvantageously decreases.

Semiconductor modules without moulding compound 304 shown in Figs. 1(a) and 1(b) are also available. It is a disadvantage that unpackaged semiconductor modules in air will often only block static voltages. Disadvantageously, a fast voltage transient may lead to a change in the field distribution along the top surface and a flashover may occur in the termination zone.

Thus, it is necessary to provide an insulation in form of a solid body made of dielectric material which is provided on the termination zone. Usually, (for example in the TO/220 package), the moulding compound is adhered to the chip surface. Furthermore many power modules are filled with silicone soft gel, as disclosed by L. Zehringer et al, "Power Semiconductor Materials and Devices", Materials Research Society Symposium Proceedings, volume 483, 1998, pages 369-380.

A major disadvantage of the conventional set up of the semiconductor modules using solid dielectrics, e.g. moulding compounds, is the high coefficient of thermal expansion (CTE) of these materials. Matching of the coefficient of thermal expansion of the moulding compounds to the coefficient of thermal expansion of the chip material in order to prevent delamination under cyclic thermal loads sometimes is not feasible.

In many cases the moulding compounds must form interfaces to other materials, e.g. copper lead frame, aluminium bonding wires, etc. It is a disadvantage that a precise parameter tuning cannot be achieved.

Semiconductor modules using silicone soft gel have the disadvantage that surfaces may be contaminated due to the silicone.

Furthermore it is inexpedient that the moulding process requires very clean environment, because material in contact with a chip termination area, e.g. the planar edge termination units must be kept within close chemical specifications, e.g. with respect to ionic contents, contamination, etc.

### SUMMARY

It is therefore an object of the present invention to provide a semiconductor module and a method of packaging a semiconductor module which avoid the disadvantages of semiconductor packages according to prior art.

The object is achieved by a semiconductor module designed according to independent claims 1 or 11. Furthermore the above object is achieved by a method of picking a semiconductor module in accordance with independent claim 21.

Further preferred developments of the present invention are according to the sub-claims.

A core idea of the present invention is to replace the conventional moulding compound by a thin insulating foil which overlaps the chip surfaces at least by the termination area. An essential idea of the present invention is to provide a polymer foil insulation wherein the foil covers the edge termination area, e.g. the planar edges of the chip surface and which can extend outwards to provide enough creepage distance in order to reach other components of the semiconductor module.

It is an advantage of the present invention that side contacting can still be performed by conventional wire bonding or by press pole for double sided cooling.

Furthermore it is expedient that openings in the foil extend throughout most of emitter and gate areas of the semiconductor die.

Furthermore it is an advantage that the foil can be shaped in three dimensions to accommodate height differences.

Advantageously foil attachment may be provided by adhesive bonding, thermo-compressing bonding or mechanical pressing. Moreover a laminated stack of foils may be provided.

According to a major aspect of the present invention a semiconductor module is provided which comprises:
a) a base member;
b) a semiconductor die, having:
   b1) contacting units for electric connection of the single conductor die to external units; and
   b2) a planar edge termination unit;
c) a fastening unit for fastening the semiconductor die to the base member; and
d) an insulating foil for insulating the planar edge termination unit.

According to another aspect of the present invention, a semiconductor module comprises a base member, a semiconductor die having contacting units for electric connections of the semiconductor die to external circuit units and a planar edge termination unit, a fastening unit for fastening the semiconductor die to the base member, a top side member, a fastening unit for fastening the top side member to the semiconductor die, and an insulating foil for insulating the planar edge termination unit.

According to a further aspect of the present invention, a method of packaging a semiconductor module is provided, wherein the test method comprises the steps of:
a) providing a base member;
b) providing a semiconductor die, having:
   b1) contacting units for electric connection of the semiconductor die to external circuit units; and
   b2) a planar edge termination unit;
c) fastening the semiconductor die to the base member by means of fastening units; and
d) insulating the planar edge termination unit by means of an insulating foil.

Preferred developments of the present invention are according to the sub-claims.

According to a preferred development of the present invention the semiconductor die is provided as a high voltage diode or as a high voltage switch.

According to another preferred development of the present invention, the planar edge termination unit is formed as a guard ring for controlled electric field reduction.

According to yet another preferred development of the present invention, the insulating foil is formed of at least one of a polymeric foil, a polyamide foil, a ceramic foil, and a fibre reinforced sheet. It is an advantage to provide the insulating foil as a multi-layered foil comprising different layers joined at at least one chip edge.

According to yet another preferred development of the present invention, the fastening units are comprised of sintered interfaces.

According to yet another preferred development of the present invention the semiconductor module comprises an alignment unit.

It is preferred that the insulating foil extends beyond the edge termination unit by at least a creepage distance of the semiconductor die.

According to yet another preferred development of the present invention, the insulating foil and the edge termination unit have identical or nearly coefficients of thermal expansion.

According to yet another preferred development of the present invention, the insulating foil is shaped in three dimensions. Advantageously the three-dimensional form of the insulating foil is a means to accommodate height differences.

According to yet another preferred development of the present invention, the insulating foil is attached by adhesive bonding, thermal compressing bonding or mechanical pressing. Furthermore it is expedient, that the insulating foil is attached by using a hot pressing technique or by using laser welding.

According to yet another preferred development of the present invention, the insulating foil is laminated onto the semiconductor die. Advantageously the insulating foil is also laminated onto the edge termination units of the semiconductor die.

According to yet another preferred development of the present invention, the planar edge termination unit is formed as a guard ring such that it reduces the electric field applied to the semiconductor die.

According to yet another preferred development of the present invention, the insulating foil is connected to the semiconductor die at at least one chip edge.

### DRAWINGS

Embodiments of the present invention are depicted in the drawings and are detailed in the description which follows.

In the drawings:
- Fig. 1(a): illustrates a quarter (1/4) cross section of a conventional semiconductor module insulated by a moulding compound;
- Fig. 1(b): illustrates a semiconductor module as shown in Fig. 1(a) with an additional top side member for contacting the top side of the semiconductor die according to a semiconductor package of the state of the art.
- Fig. 2(a): illustrates a semiconductor module having an insulating foil according to a preferred embodiment of the present invention;
- Fig. 2(b): illustrates a semiconductor module according to Fig. 2(a) with an additional top side member instead of a bonding wire for contacting the top side of the semiconductor die;
- Fig. 3: illustrates a semiconductor module which is constructed as shown in Fig. 2(b) with attached heat dissipation means; and
- Fig. 4: illustrates a semiconductor module without a top side member according to Fig. 2(a), wherein the insulating foil is formed in three dimensions.

In the figures, same reference numerals denote the same or similar parts.

### DESCRIPTION

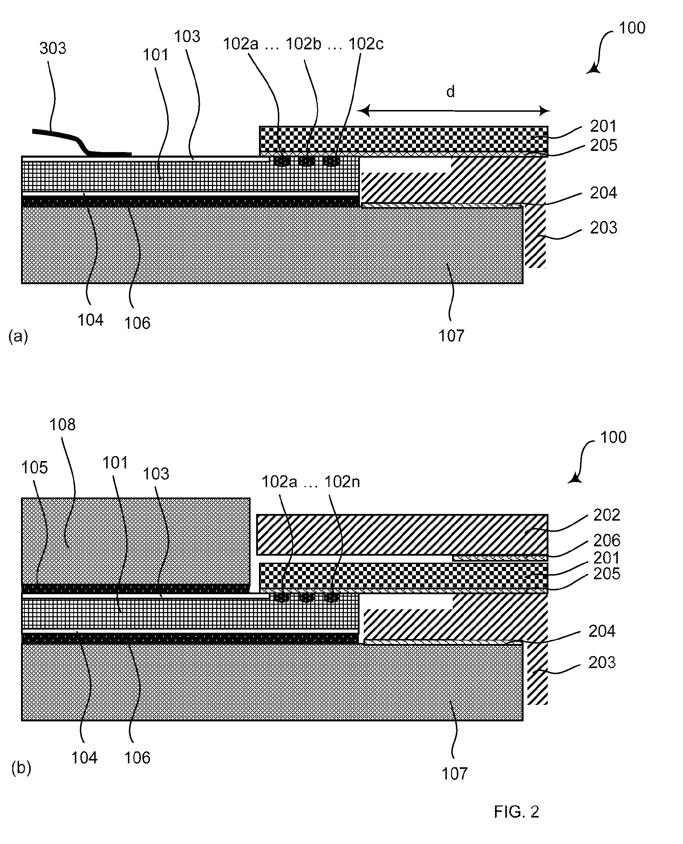

A semiconductor module according to a first preferred embodiment of the present invention is described with reference to Fig. 2(a).

As shown in Fig. 2(a) the base member 107 used as a base plate is provided with a second fastening unit 106. A semiconductor die 101 having a first contacting unit 103 on the top side and a second contacting unit 104 on the bottom side is fixed with the base member 107 by means of the second fastening unit 106. In order to provide a controlled electric field reduction of an electric field which is applied to the semiconductor die 101, the semiconductor die comprises a planar edge termination unit 102a-n. The planar edge termination unit can be comprised of a guard ringed structure that controls the electric field along the top surface of the semiconductor die 101. In Fig. 2(a), three guard rings 102a, 102b and 102c are shown as an example.

It is noted that an arbitrary number of guard rings 102a,...,102e,...,102n may be provided in order to provide a controlled electric field reduction.

It is also possible to have another edge termination type like ohmic resistive or semiconducting layers, in particular in form of rings.

In the arrangement shown in Fig.2(a), the top side of the semiconductor die is contacted by means of a bonding wire 303 via the first contacting unit 103. The first contacting unit 103 is provided on top of the top surface of the semiconductor die 101 except for regions which are occupied by the planar edge termination units 102a - 102n (the guard rings).

Instead of providing a moulding compound for an electrical insulation as it is done in the state of the art (see Figs. 1(a) and 1(b)), the semiconductor module shown in Fig.2(a) has an insulating foil 201 which is flat compared to the lateral dimensions of the semiconductor module.

It is noted that Figs. 1(a), 1(b), 2(a), 2(b), 3 and 4 respectively exhibit a quarter (1/4) cross section of a discreet semiconductor module.

The insulating foil 201 shown in Fig. 2(a) is provided as a polymeric foil, polyamide foil, a ceramic foil and/or a fibre reinforced sheet. In order to fasten the insulating foil 201 on top of the semiconductor die 101 and adjacent components, an alignment unit 203 is provided in order to compensate height differences at the edge of the semiconductor die. It is necessary that the insulating foil 201 covers the edge termination units 102a-102c of the semiconductor die 101.

Furthermore it is advantageous if the insulating foil 201 extends sideways, to the right side Fig.2(a) in order to provide a creepage distance d for currents flowing from upper electrodes, e.g. the first contacting unit 103 to lower electrodes, e.g. the second contacting unit 104 of the semiconductor die 101. The lateral dimensions of the insulating foil 201 depend on the voltage differences applied to the semiconductor 301. As depicted in Fig.2(a), two additional adhesive layers are provided, e.g. a first adhesive layer 204 and a second adhesive layer 205. These layers are used for fixing the alignment unit 203 at the base member 107 (first adhesive layer 204) and for fixing the insulating foil 201 at the alignment unit 203 (second adhesive layer 205).

It is noted that the second adhesive layer 205 may extend from the alignment unit 203 towards the semiconductor die 101 such that the edge termination units 102a, 102b and 102c are covered by the second adhesive layer 205. An advantage of the present invention is that the insulating foil 201 may be formed of different layers joined at at least one chip edge of the semiconductor die 101.

As the requirements for electric insulation include both bulk and surface properties the dielectric strength and the surface creepage distance must be adapted for the desired voltage level. It is an advantage that polyamide foils used as the electrical insulating foil 201 provide both dielectric strength and surface creepage distance at the same time at minimum material use.

It is noted that other connection technologies except adhesive layers (first adhesive layer 204 and a second adhesive layer 205) may be provided such as hot-pressing (in case of polyamide and thermoplastic resin), laser welding and the like.

A major advantage of the embodiment of the present invention which is depicted in Fig. 2(a) is that insulating foils 201 provided as thin layers will not build up excessive shear stress on the interface but will rather follow the substrate layer they are attached to.

In Fig. 2(a), a rigid foil is used as an insulating foil 201. This provides the advantage that a stand-off structure provided as the alignment unit can be applied for adjusting the foil attachment plane to the chip top surface (the surface of the semiconductor die 101). This assists in aligning the insulating foil 201 on top of the semiconductor die 101.

Fig. 2(b) shows another preferred embodiment of the present invention. The difference compared to the embodiment shown in Fig. 2(a) is that a mechanical protection is provided on top of the semiconductor die 101 in form of a top side member 108. The additional top side member 108 is fastened on top of the first contacting unit 103 of the semiconductor 101 by means of a first fastening unit 105. The fastening units 105 and 106 act as chip interfaces for the semiconductor die 101.

It is noted that a semiconductor module 100 (semiconductor package) may comprise more than one semiconductor die 101 with the respective components shown in Figs. 2(a) and (b), whereas in Figs. 2(a) and 2(b) only one semiconductor die 101 is illustrated.

According to a preferred embodiment of the present invention, a mechanical protection element 202 is provided on top of the insulating foil 201. Advantageously, this protection element 202 can be formed as a printed circuit board serving as a control signal distribution unit. Openings (not shown) in the insulating foil 201 provide access to emitter and gate terminals of the semiconductor die 101. The dimensions of the openings depend on the tolerances of the die attachment.

As shown in Fig. 2(b), the protection element 202 fixed at the top side of the insulating foil 201 by means of a third adhesive layer 206. It is noted that the first adhesive layer 204, the second adhesive 205 and/or the third adhesive layer 206 may be provided as an acrylate, siliconeor other adhesive or the protection element 202 may be fixed at the top side of the insulating foil 201 by means of a thermo-compression-bonding

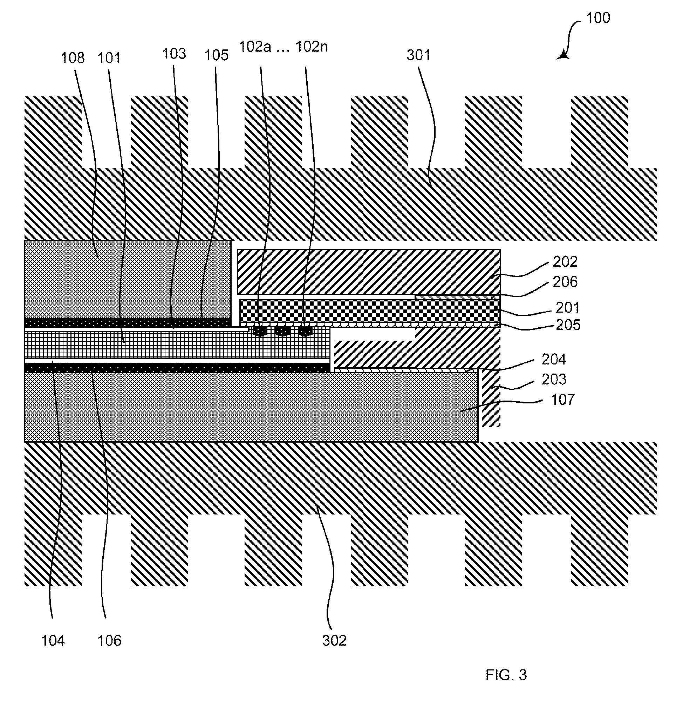

Fig. 3 shows a complete semiconductor module 100 having heat dissipation means 301, 302 on the bottom and top sides of the semiconductor die 101. A first heat dissipation means 301 is attached to the top side member 108 shown in Fig. 2(a), wherein a second heat dissipation means 302 is attached to the base member 107 shown in Figs. 2(a) and 2(b).

An arbitrary number of edge termination units 102(a) - 102(n) are protected and insulated by the insulating foil 201. As shown in Fig. 3, an air gap may be provided between the protection element 202 and the first heat dissipation means 301. Furthermore, the first heat dissipation means 301 may be fixed to the protection element 202, using another adhesive layout.

The remaining components shown in Fig. 3 respond to the components shown in Fig. 2(a) and 2(b), the description of which is omitted here in order to avoid redundant explanations.

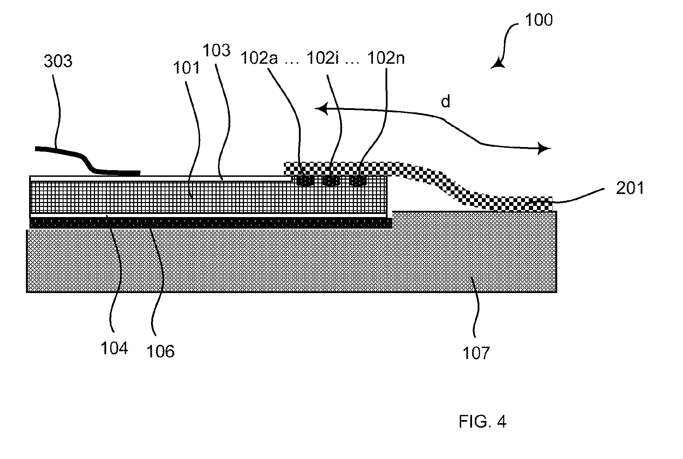

Fig. 4 illustrates a third preferred embodiment of the present invention. As shown in Fig. 4, the insulating foil 201 is now shaped in three dimensions. Compared to the embodiments shown in Fig. 2(a), 2(b) and 3, the alignment unit 203 is omitted resulting in a simplified set-up of the semiconductor module 100.

Especially in the third embodiment shown in Fig. 4, the insulating foil 201 is provided with a minimum thickness. The foil is attached directly or via an adhesive layer (not shown) at one end onto the semiconductor die 101 in a region where the edge termination units 102(a) - 102(n) are provided, and is attached at its other end directly to the base member 107. The further construction of the semiconductor module 100 is similar to that described with reference to Fig. 2(a).

It is a major advantage of the present invention that using an insulating foil 201 provided with minimum thickness, the set-up of the semiconductor module 100 can be simplified. It is a further advantage that any height differences can be accommodated by using the 3D-form of the insulating foil 201 as shown in Fig. 4.

The fastening units 105, 106 (see also Figs. 2(a), 2(b) and 3) can be comprised of sintered interfaces. The insulating foil 201 extends beyond the edge termination unit 102a - 102n by at least a required creepage distance. The minimum creepage distance to be extended by the insulating foil 201 can be required towards adjacent electrodes within the semiconductor module, e.g. between collector and emitter electrode, but the minimum creepage distance to be respected can also be required in view of other electrical elements like a gate-runner or a thermo sensor, which do not necessarily have to be within the semiconductor module, but which belong to an electrical device, in which the semiconductor module is arranged.

It is preferred that the insulating foil 201 and the edge combination unit 102a - 102n have identical or nearly coefficients of thermal expansion.

The bonding wire 303 is provided for a contact with at least one of the contacting units 103, 104.

In another preferred embodiment, not shown in a figure, the semiconductor module 100 comprises a gate electrode. The gate electrode is electrically connected to an electrical conductor which is arranged on the insulating foil 201. The electrical conductor may be an electrical conductive track along the surface of the insulating foil.

The semiconductor module 100 may also comprise a further insulating foil, which is arranged parallel to the insulating foil 201. The electrical conductor is arranged between the insulating foil (201) and the further insulating foil so that it is sandwiched between the foils. Instead of electrically connecting the gate such tracks may also be used for sensor wiring.

During manufacturing of the semiconductor module 100, the insulating foil 201 may be attached by adhesive bonding, thermo-compressing or mechanical pressing. Furthermore, the insulating foil may be attached by using a hot pressing technique or laser welding. Especially in the set-up shown in Fig. 4, the insulating foil 201 may be laminated onto the top surfaces of the semiconductor die 101 and the base member 107. Different layers may be applied onto the semiconductor die 101 and the base member 107 in order to build up the insulating foil 201.

A further advantage of the semiconductor module 100 provided by the present invention is that double sided cooling (as shown in Fig. 3) may be provided because no space consuming moulding compound is required (compare with state of the art devices, Figs. 1(a) and (b)).

Moreover, manufacturing costs are reduced to the simple construction of the insulating foil 201. Even if insulating foils provided with minimum thickness are used, which have a coefficient of thermal expansion in the order of 20 up to 200 ppm/K compared to the coefficient of thermal expansion the semiconductor die 101 in the order of 2 to 4 ppm/K, the construction of the insulating foil 201 poses no problems caused by differences in the respective coefficients of thermal expansion CTE.

Furthermore, no adhering problems are caused by the insulating foil 201 compared to highly filled moulding compounds used in conventional devices. Such adhering problems may be caused by flaking off parts of moulding compounds which is much less a problem with insulating foils according to the present invention.

### LIST OF REFERENCE NUMERALS

- 100: Semiconductor module
- 101: Semiconductor die
- 102a-102n: Edge termination unit
- 103: First contacting unit
- 104: Second contacting unit
- 105: First fastening unit
- 106: Second fastening unit
- 107: Base member
- 108: Top side member
- 201: Insulating foil
- 202: Protection element
- 203: Alignment unit
- 204: First adhesive layer
- 205: Second adhesive layer
- 206: Third adhesive layer
- 301: First heat dissipation means
- 302: Second heat dissipation means
- 303: Bonding wire
- 304: Moulding compound

## Claims

1. A semiconductor module (100), comprising:
a) a base member (107);
b) a semiconductor die (101), having:
b1) contacting units (103, 104) for electrical connection of the semiconductor die (101) to external circuit units; and
b2) a planar edge termination unit (102a-102n);
c) a fastening unit (106) for fastening the semiconductor die (101) to the base member (107); **characterized in that**
d) the semiconductor module (100) comprises an insulating foil (201) for insulating the planar edge termination unit (102a-102n).

2. The semiconductor module (100) according to claim 1, wherein the semiconductor die (101) is provided as a high voltage diode or as a high voltage switch (IGBT).

3. The semiconductor module (100) according to claim 1, wherein the planar edge termination unit (102a-102n) is formed as a guard ring or an ohmic resistive or a semiconducting layer for controlled electric field reduction.

4. The semiconductor module (100) according to claim 1, wherein the insulating foil (201) is formed of at least one of a polymeric foil, a polyamide foil, a ceramic foil, and a fibre reinforced sheet.

5. The semiconductor module (100) according to claim 1, wherein the insulating foil (201) is formed of different layers joined at at least one chip edge.

6. The semiconductor module (100) according to claim 1, wherein the fastening units (105, 106) are comprised of sintered interfaces.

7. The semiconductor module (100) according to claim 1, wherein the semiconductor module (100) comprises an alignment unit (203).

8. The semiconductor module (100) according to claim 1, wherein the insulating foil (201) extends beyond the edge termination unit (102a-102n) by at least a required creepage distance (d).

9. The semiconductor module (100) according to claim 1, wherein the insulating foil (201) and the edge termination unit (102a-102n) have the same coefficients of thermal expansion (CTE).

10. The semiconductor module (100) according to claim 1, wherein at least one of the contacting units (103, 104) is connected to a bonding wire (303).

11. A semiconductor module (100), comprising:
a) a base member (107);
b) a semiconductor die (101), having:
b1) contacting units (103, 104) for electrical connection of the semiconductor die (101) to external circuit units; and
b2) a planar edge termination unit (102a-102n);
c) a fastening unit (106) for fastening the semiconductor die (101) to the base member (107);
d) a top side member (108);
e) a fastening unit (105) for fastening to the top side member (108) to the semiconductor die (101); and
d) an insulating foil (201) for insulating the planar edge termination unit (102a-102n).

12. The semiconductor module (100) according to claim 11, wherein the semiconductor die (101) is provided as a high voltage diode or as a high voltage switch (IGBT).

13. The semiconductor module (100) according to claim 11, wherein the planar edge termination unit (102a-102n) is formed as a guard ring or an ohmic resistive or a semiconducting layer for controlled electric field reduction.

14. The semiconductor module (100) according to claim 11, wherein the insulating foil (201) is formed of at least one of a polymeric foil, a polyamide foil, a ceramic foil, and a fibre reinforced sheet.

15. The semiconductor module (100) according to claim 11, wherein the insulating foil (201) is formed of different layers joined at at least one chip edge.

16. The semiconductor module (100) according to claim 11, wherein the fastening units (105, 106) are comprised of sintered interfaces.

17. The semiconductor module (100) according to claim 11, wherein the semiconductor module (100) comprises an alignment unit (203).

18. The semiconductor module (100) according to claim 11,
wherein the insulating foil (201) extends beyond the edge termination unit (102a-102n) by at least a required creepage distance (d).

19. The semiconductor module (100) according to claim 11, wherein the insulating foil (201) and the edge termination unit (102a-102n) have nearly identical coefficients of thermal expansion (CTE).

20. The semiconductor module (100) according to claim 11, wherein at least one of the contacting units (103, 104) are connected to a bonding wire (303).

21. The semiconductor module (100) according to claim 1, wherein the semiconductor module (100) comprises a gate electrode and the gate electrode is connected to an electrical conductor which is arranged on the insulating foil (201).

22. The semiconductor module (100) according to claim 21, wherein the electrical conductor is an electrical conductive track along the surface of the insulating foil.

23. The semiconductor module (100) according to claim 21 or 22,
wherein the semiconductor module (100) comprises a further insulating foil and the electrical conductor is arranged between the insulating foil (201) and the further insulating foil.

24. A method of packaging a semiconductor module (100), the method having the following steps:
a) providing a base member (107);
b) providing a semiconductor die (101), having:
b1) contacting units (103, 104) for electrical connection of the semiconductor die (101) to external circuit units; and
b2) a planar edge termination unit (102a-102n);
c) fastening the semiconductor die (101) to the base member (107) by means of fastening units (105, 106); and
d) insulating the planar edge termination unit (102a-102n) by means of an insulating foil (201).

25. The method of packaging a semiconductor module (100) according to claim 24,
wherein the insulating foil (201) is shaped in three dimensions.

26. The method of packaging a semiconductor module (100) according to claim 24,
wherein the insulating foil (201) is attached by adhesive bonding, thermo-compression bonding or mechanical pressing.

27. The method of packaging a semiconductor module (100) according to claim 24,
wherein the insulating foil (201) is attached by using a hot pressing technique or laser welding.

28. The method of packaging a semiconductor module (100) according to claim 24,
wherein the insulating foil (201) is laminated onto the semiconductor die (101).

29. The method of packaging a semiconductor module (100) according to claim 24,
wherein the planar edge termination unit (102a-102n) is formed as a guard ring or an ohmic resistive or a semiconducting layer and reduces the electric field applied to the semiconductor die.

30. The method of packaging a semiconductor module (100) according to claim 24,
wherein the insulating foil (201) is formed of at least one of a polymeric foil, a polyamide foil, a ceramic foil, and a fibre reinforced sheet.

31. The method of packaging a semiconductor module (100) according to claim 24,
wherein the insulating foil (201) is formed of different layers connected to each other at at least one chip edge.

32. The method of packaging a semiconductor module (100) according to claim 24,
wherein the fastening units (105, 106) are provided as sintered interfaces.

33. The method of packaging a semiconductor module (100) according to claim 24, wherein the insulating foil (201)
